# EUROPEAN PATENT APPLICATION

(11) **EP 4 611 111 A1**
(43) Date of publication of application: **03.09.2025**
(21) Application number: 24741630.8
(22) Date of filing: 04.01.2024
(51) Int. Cl.: H01M 10/42, H01M 10/48, G01R 31/36

(54) **TEST JIG**

(30) Priority: 13.01.2023 KR 20230005564
(71) Applicant: LG Energy Solution, Ltd., Seoul 07335 (KR)
(72) Inventor: LEE, Jong Hoon, Daejeon 34122 (KR); BAEK, Sang Min, Daejeon 34122 (KR); YI, Young Mi, Daejeon 34122 (KR)
(74) Representative: Goddar, Heinz J.
(86) International application number: PCT/KR2024/000219
(87) International publication number: WO 2024/151008

(57) **Abstract**

An experimental jig according to an embodiment of the present invention may include a first plate, a second plate that is disposed to be spaced a constant distance from the first plate so that a secondary battery is disposed between the first plate and the second plate, a coupling part that passes through the first plate and the second plate to couple the first plate and the second to each other, and a side plate that is disposed between the first plate and the second plate in a state, in which the coupling part passes through the side plate, to surround a side surface of the secondary battery.

## Description

### TECHNICAL FIELD

The present application claims the benefit of the priority of Korean Patent Application No. 10-2023-0005564, filed on January 13, 2023, which is hereby incorporated by reference in its entirety.

The present disclosure herein relates to an experimental jig that surrounds a secondary battery to experiment performance of the secondary battery.

### BACKGROUND ART

In general, types of secondary batteries include nickel-cadmium batteries, nickel-hydrogen batteries, lithium-ion batteries, lithium-ion polymer batteries, and the like. These secondary batteries are applied to and used in not only small-sized products such as digital camera, P-DVD, MP3P, mobile phone, PDA, portable game device, power tool and E-bike, but also large-sized products such as electric vehicle or hybrid vehicle, which require high output, energy storage systems for storing surplus electricity or new renewable energy, and energy storage systems for backup.

In order to manufacture these secondary batteries, a positive electrode current collector and a negative electrode current collector are coated with electrode active material slurry to manufacture a positive electrode and a negative electrode, and then the positive electrode and the negative electrode are stacked on both sides of a separator to provide an electrode assembly having a predetermined shape. Thereafter, a battery case accommodates the electrode assembly and is sealed after injection of an electrolyte.

The secondary batteries undergone activation of electrode assemblies may accumulate electrical energy, and output the accumulated electrical energy according to design and when necessary. As such, in order for the secondary batteries to be used in the field, a process of testing performance of the secondary batteries is performed, and tools that grip the secondary batteries are used to test the secondary batteries.

However, there is often a problem that an environment in which an experiment is performed by gripping the secondary batteries, and an environment to which the secondary batteries are applied are somewhat different from each other to lead a decrease in experimental accuracy. Thus, there is a need for tools that grip the secondary batteries and also create an environment similar to the environment, to which the secondary batteries are actually applied, so that the accuracy of the secondary battery performance test is increased.

### DISCLOSURE OF THE INVENTION

### TECHNICAL PROBLEM

An object of the present invention for solving the above problems is to provide an experimental jig for a secondary battery, which creates an environment similar to an environment to which the secondary battery is actually applied.

### TECHNICAL SOLUTION

An experimental jig according to an embodiment of the present invention may include a first plate, a second plate that is disposed to be spaced a constant distance from the first plate so that a secondary battery is disposed between the first plate and the second plate, a coupling part that passes through the first plate and the second plate to couple the first plate and the second plate to each other, and a side plate that is disposed between the first plate and the second plate in a state, in which the coupling part passes through the side plate, to surround a side surface of the secondary battery.

The side plate may include a fixed plate that is disposed on one side of the first plate and the second plate, and a movable plate that is disposed on the other side of the first plate and the second plate, which is opposite to a position of the fixed plate, and is movable by a predetermined distance in a longitudinal direction of the first plate and the second plate.

The movable plate may include a plurality of coupling holes through each of which the coupling part passes.

Each of the coupling holes may be defined in the longitudinal direction of the first plate and the second plate so that the movable plate is movable.

The coupling hole may be defined in a direction diagonal to the longitudinal direction of the first plate.

Each of the coupling holes may have a shape that is gradually away from the fixed plate in a direction in which the movable plate is inserted between the first plate and the second plate.

The movable plate may be inserted between the first plate and the second plate in the longitudinal direction of the first plate and the second plate.

As the movable plate is inserted between the first plate and the second plate, the movable plate may be spaced apart from the secondary battery.

The fixed plate may be in close contact with the secondary battery.

As the movable plate is inserted between the first plate and the second plate, a distance between the movable plate and the fixed plate may increase.

One surface of the fixed plate that is in contact with the secondary battery may include an arch structure.

A length of the movable plate may be greater than a length of the fixed plate.

The side plate may be provided in pair to be disposed on both sides of the secondary battery, respectively. One of the pair of side plates may surround one surface of the secondary battery, and the other of the pair of side plates may be spaced a constant distance from the other surface of the secondary battery.

### ADVANTAGEOUS EFFECTS

According to the preferred embodiments of the present invention, the environment similar to the environment to which the secondary battery is actually applied may be created to increase the experimental accuracy of the secondary battery performance test.

In addition, the effects may be included which are easily predictable by those skilled in the art from the configurations according to the preferred embodiments of the present invention.

### BRIEF DESCRIPTION OF THE DRAWINGS

The following drawings attached in this specification illustrate preferred embodiments of the present invention and function to make further understood the technical spirit of the present invention along with the detailed description of the invention. Thus, the present invention should not be construed as being limited by only the embodiments illustrated in the drawings.
FIG. 1 is a perspective view of an experimental jig according to an embodiment of the present invention.
FIG. 2 is a perspective view of a state in which a second plate is removed according to an embodiment of the present invention.
FIG. 3 is a perspective view of a state in which a secondary battery is seated on a first plate according to an embodiment of the present invention.
FIG. 4 is a plan view of a movable plate according to an embodiment of the present invention.
FIG. 5 is a cross-sectional view of a state before a movable plate is inserted according to an embodiment of the present invention.
FIG. 6 is a cross-sectional view of a state after a movable plate is inserted according to an embodiment of the present invention.
FIG. 7 is a plan view of a state in which a secondary battery is seated between side plates according to another embodiment of the present invention.

### MODE FOR CARRYING OUT THE INVENTION

Hereinafter, preferred embodiments of the present invention will be described in detail with reference to the accompanying drawings to enable those skilled in the art to which the present invention pertains to easily carry out the present invention. The present invention may, however, be embodied in different forms and should not be construed as limited by the embodiments set forth herein.

The parts unrelated to the description, or the detailed descriptions of related well-known art that may unnecessarily obscure subject matters of the present invention, will be ruled out in order to clearly describe the present invention. In assigning reference numerals to elements in each drawing in this specification, like reference numerals refer to like elements throughout the whole specification.

Moreover, terms or words used in this specification and claims should not be restrictively interpreted as ordinary meanings or dictionary-based meanings, but should be interpreted as meanings and concepts conforming to the scope of the present invention on the basis of the principle that an inventor can properly define the concept of a term to describe and explain his or her invention in the best ways.

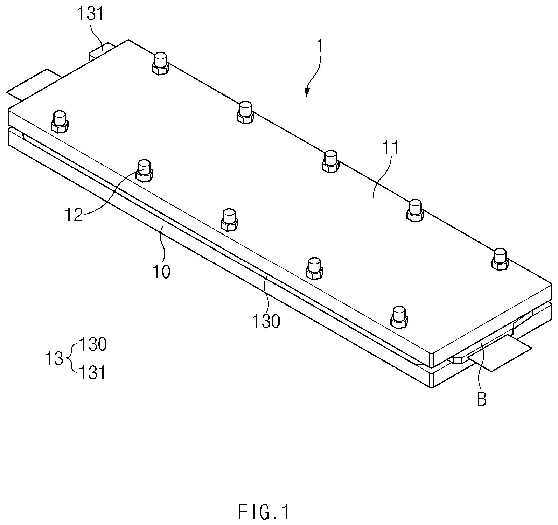

FIG. 1 is a perspective view of an experimental jig 1 according to an embodiment of the present invention.

Referring to FIG. 1, the experimental jig 1 according to an embodiment of the present invention may surround and grip a secondary battery B. For example, in order to test performance of the secondary battery B, the experimental jig 1 may surround the secondary battery B in a longitudinal direction of the secondary battery B. In this case, the experimental jig 1 may surround an outer surface of the secondary battery B except for both ends of the secondary battery B on which lead tabs are provided.

Specifically, the experimental jig 1 may surround the secondary battery B so as to be spaced apart only from one specific surface of the secondary battery B. For example, in a state in which the secondary battery B is disposed so that the secondary battery B stands, the experimental jig 1 may grip the secondary battery B so as to be spaced a constant distance only from a top surface of the secondary battery B. Accordingly, an environment similar to the environment to which the secondary battery B is actually applied may be created. According to this structure of the experimental jig 1, the experimental jig 1 may create an environment more similar to actually applied environment so that when the performance of the secondary battery B is experimented, experimental accuracy is more increased.

More specifically, the experimental jig 1 may include a first plate 10, a second plate 11, a coupling part 12, and a side plate 13.

The first plate 10 may be disposed below the secondary battery B to support the secondary battery B. For example, in a state in which the first plate 10 is placed, the secondary battery B may be seated on a top surface of the first plate 10.

The second plate 11 may be disposed to be spaced a constant distance from the first plate 10 so that the secondary battery B is disposed between the first plate 10 and the second plate 11. For example, in a state in which the secondary battery B is seated on the top surface of the first plate 10, the second plate 11 may cover an upper side of the secondary battery B. According to this structure, as the secondary battery B is disposed in a state of being interposed between the first plate 10 and the second plate 11, movement of the secondary battery B may be restricted.

The coupling part 12 may pass through the first plate 10 and the second plate 11 to couple the first plate 10 and the second plate 11 to each other. For example, the coupling part 12 may include a bolt, a nut, and the like, to couple the first plate 10 and the second plate 11 to each other through screw coupling that passes through the first plate 10 and the second plate 11. Specifically, the coupling part 12 may be provided in plurality to be disposed in both sides of the first plate 10 and the second plate 11 in the longitudinal direction of the first plate 10 and the second plate 11.

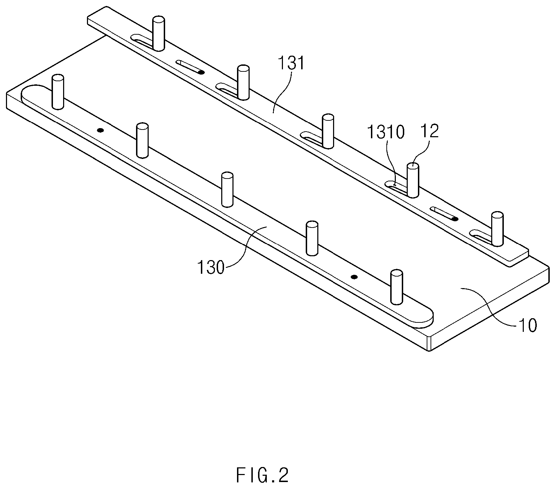

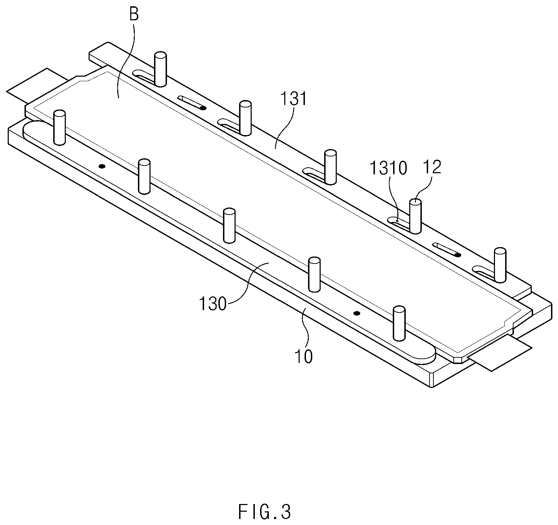

FIG. 2 is a perspective view of a state in which the second plate 11 is removed according to an embodiment of the present invention. FIG. 3 is a perspective view of a state in which the secondary battery B is seated on the first plate 10 according to an embodiment of the present invention. That is, the secondary battery B may be in the state in FIG. 3 by being seated on the first plate 10 in the state in FIG. 2.

Referring to FIGS. 2 and 3, the side plate 13 may be disposed between the first plate 10 and the second plate 11 in a state, in which the coupling part 12 passes through the side plate 13, to surround a side surface of the secondary battery B. For example, the side plate 13 may be provided in a pair to be disposed on both sides of the secondary battery B, respectively.

One of the pair of side plates 13 may surround one surface of the secondary battery B, and the other of the pair of side plates 13 may be spaced a certain distance from the other surface of the secondary battery B. Specifically, as one of the pair of side plates 13 is inserted between the first plate 10 and the second plate 11 in a state in which the pair of side plates 13 surround both the sides of the secondary battery B, the inserted side plate 13 may be spaced a constant distance from the secondary battery B.

The side plate 13 may include a fixed plate 130 and a movable plate 131.

The fixed plate 130 may be disposed on one side of the first plate 10 and the second plate 11. For example, the fixed plate 130 may be disposed along one side surface of each of the first plate 10 and the second plate 11 on the basis of the longitudinal direction of the first plate 10 and the second plate 11. Specifically, when viewed from above, in a state of not being moving out of an area on which the first plate 10 and the second plate 11 are disposed, the fixed plate 130 may be disposed along the one side surface of each of the first plate 10 and the second plate 11.

The coupling part 12 may be provided to pass through the first plate 10, the fixed plate 130, and the second plate 11 in this order so that the fixed plate 130 is fixed between the first plate 10 and the second plate 11. In this case, the fixed plate 130 may be in contact with the secondary battery B to support the secondary battery B. That is, the fixed plate 130 may be in close contact with the secondary battery B.

The movable plate 131 may be disposed on the other side of the first plate 10 and the second plate 11, which is opposite to a position of the fixed plate 130. For example, the movable plate 131 may be disposed along the other side surface of each of the first plate 10 and the second plate 11, which is positioned at an opposite side of the fixed plate 130, on the basis of the longitudinal direction of the first plate 10 and the second plate 11.

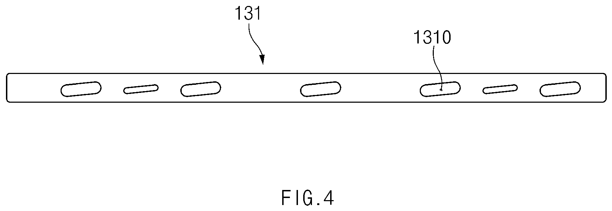

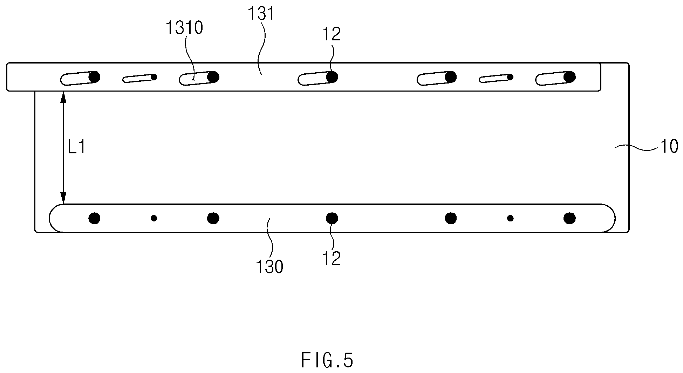

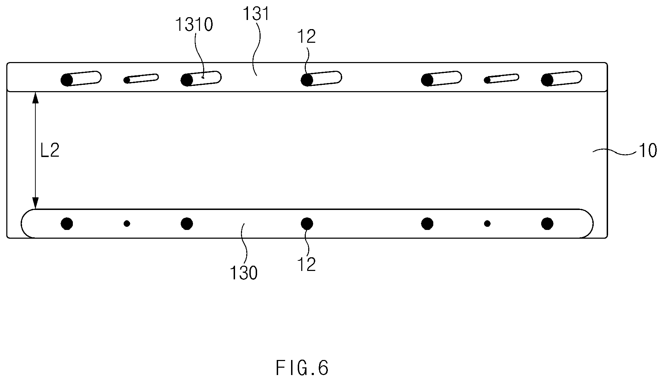

FIG. 4 is a plan view of the movable plate 131 according to an embodiment of the present invention. FIG. 5 is a cross-sectional view of a state before the movable plate 131 is inserted according to an embodiment of the present invention. FIG. 6 is a cross-sectional view of a state after the movable plate 131 is inserted according to an embodiment of the present invention.

Referring to FIGS. 4 to 6, the movable plate 131 may be movable by a predetermined distance in the longitudinal direction of the first plate 10 and the second plate 11. For example, in a state in which a portion of the movable plate 131 protrudes from the first plate 10 and the second plate 11, the movable plate 131 may be inserted between the first plate 10 and the second plate 11 in the longitudinal direction of the first plate 10 and the second plate 11.

Specifically, the movable plate 131 may include a plurality of coupling holes 1310 through each of which a coupling part 12 passes. The plurality of coupling holes 1310 may be penetrated portions, and may be arranged in the longitudinal direction of the movable plate 131.

In this case, each of the coupling holes 1310 may be defined in the longitudinal direction of the first plate 10 and the second plate 11 so that the movable plate 131 is movable. That is, in a state in which the coupling part 12 passes through the movable plate 131 through the coupling hole 1310, the movable plate 131 may be moved in a direction in which the coupling hole 1310 is defined.

The coupling hole 1310 may be defined in a direction diagonal to the longitudinal direction of the first plate 10. In other words, the coupling hole 1310 may have a shape that is gradually away from the fixed plate 130 in a direction in which the movable plate 131 is inserted between the first plate 10 and the second plate 11.

According to this structure, as the movable plate 131 is inserted between the first plate 10 and the second plate 11, the movable plate 131 may be spaced apart from the secondary battery B. That is, in a state in which the fixed plate 130 and the movable plate 131 are in contact with both the side surfaces of the secondary battery B, respectively, as the movable plate 131 is inserted between the first plate 10 and the second plate 11, a distance between the movable plate 131 and the secondary battery B may increase. In other words, as the movable plate 131 is inserted between the first plate 10 and the second plate 11, a distance between the movable plate 131 and the fixed plate 130 may increase. In this case, a state in which the fixed plate 130 is in contact with one side surface of the secondary battery B may be maintained.

Specifically, when the movable plate 131 is inserted backward from a front side, a distance between a front end of the fixed plate 130 and the movable plate 131 before the movable plate 131 is inserted may be referred to as L₁, and a distance between the front end of the fixed plate 130 and the movable plate 131 after the movable plate 131 is inserted may be referred to as L₂. A difference between the distance before the insertion and the distance after the insertion may be 1.5 mm to 3.5 mm. In a case in which the difference between the distance L₁ before the insertion and the distance L₂ after the insertion is less than 1.5 mm, a space between the secondary battery B and the movable plate 131 may be decreased, and thus, an experimental environment through a fixing jig may be different from the actually applied environment. In addition, in a case in which the difference between the distance L₁ before the insertion and the distance L₂ after the insertion is more than 3.5 mm, the secondary battery B and the movable plate 131 may be excessively spaced apart from each other, and likewise, the experimental environment through the fixing jig may be different from the actually applied environment.

As a result, in a state in which one surface of the secondary battery B is in close contact with the fixed plate 130, and the other surface of the secondary battery B is spaced a certain distance from the movable plate 131, a performance test may be performed on the secondary battery B. To sum up, a situation in which the secondary battery B is applied to an actual module may be a situation in which a bottom surface of the secondary battery B is supported to restrict a phenomenon in which the bottom surface of the secondary battery B is swollen, and also a certain space for a top surface of the secondary battery B is secured. Thus, the fixing jig may create the actually applied environment as above as it is, and thus, in an experiment of the performance of the secondary battery B, the accuracy of the experiment may be more increased.

Hereinafter, a fixed plate 130 according to another embodiment of the present invention will be described. The same as described above with respect to the fixing jig will be omitted.

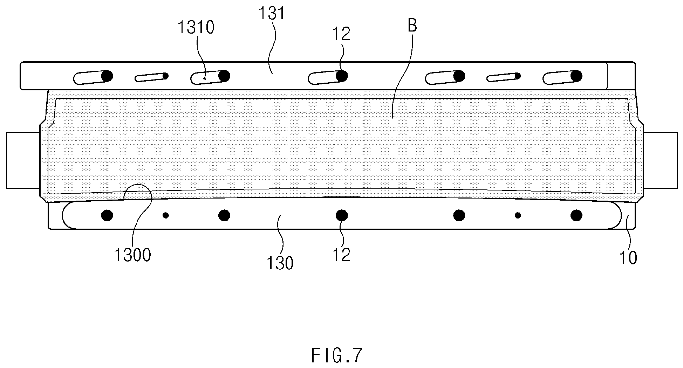

FIG. 7 is a plan view of a state in which a secondary battery B is seated between side plates 13 according to another embodiment of the present invention.

Referring to FIG. 7, one surface 1300 of the fixed plate 130 which is in contact with the secondary battery B may include an arch structure. That is, the one surface 1300 of the fixed plate 130 which is in contact with the secondary battery B may be provided to be convex toward the secondary battery B. The secondary battery B may include a surface that is concave toward the fixed plate 130 so as to correspond to a shape of the one surface 1300 of the fixed plate 130. In other words, the secondary battery B may have a shape that sags toward the fixed plate 130, and be in closer contact with the fixed plate 130.

According to this structure, one surface of the secondary battery B, which is in contact with the one surface 1300 of the fixed plate 130, may be a portion that is a bottom surface of the secondary battery B when the secondary battery B is applied to the actual module. As a result, as the secondary battery B includes a shape that is in closer contact with the fixed plate 130 and slightly sags in the fixing jig, the fixing jig may provide an environment more similar to the actually applied environment to further increase the accuracy of the performance experiment of the secondary battery B.

In addition, a length of a movable plate 131 may be greater than a length of the fixed plate 130. This structure may assist a user in more easily press and insert the movable plate 131. Additionally, this structure may function so that when handling the fixed plate 130 and the movable plate 131, the user may dispose the secondary battery B at an accurate position without confusing both side surfaces of the secondary battery B that face the fixed plate 130 and the movable plate 131.

The description of the present invention is intended to be illustrative, and various changes and modifications can be made by those of ordinary skill in the art to which the present invention pertains, without departing from the spirit and scope of the present invention as defined by the appended claims.

Therefore, the embodiments set forth herein are to describe the technical spirit of the present invention and not to limit. The scope of the technical spirit of the present invention is not limited by the embodiments.

Moreover, the protective scope of the present invention should be determined by reasonable interpretation of the appended claims and all technical concepts coming within the equivalency range of the present application should be interpreted to be in the scope of the right of the present application.

### [Description of the Symbols]

1: Experimental jig
10: First plate
11: Second plate
12: Coupling part
13: Side plate
130: Fixed plate
131: Movable plate
1300: One surface of first plate
1310: Coupling hole

## Claims

1. An experimental jig comprising:
a first plate;
a second plate disposed to be spaced a constant distance from the first plate so that a secondary battery is disposed between the first plate and the second plate;
a coupling part passing through the first plate and the second plate to couple the first plate and the second plate to each other; and
a side plate disposed between the first plate and the second plate in a state, in which the coupling part passes through the side plate, to surround a side surface of the secondary battery.

2. The experimental jig of claim 1, wherein the side plate comprises:
a fixed plate disposed on one side of the first plate and the second plate; and
a movable plate that is disposed on the other side of the first plate and the second plate, which is opposite to a position of the fixed plate, and is movable by a predetermined distance in a longitudinal direction of the first plate and the second plate.

3. The experimental jig of claim 2, wherein the movable plate comprises a plurality of coupling holes through each of which the coupling part passes,
wherein each of the coupling holes is defined in the longitudinal direction of the first plate and the second plate so that the movable plate is movable.

4. The experimental jig of claim 3, wherein the coupling hole is defined in a direction diagonal to the longitudinal direction of the first plate.

5. The experimental jig of claim 4, wherein each of the coupling holes has a shape that is gradually away from the fixed plate in a direction in which the movable plate is inserted between the first plate and the second plate.

6. The experimental jig of claim 2, wherein the movable plate is inserted between the first plate and the second plate in the longitudinal direction of the first plate and the second plate.

7. The experimental jig of claim 6, wherein, as the movable plate is inserted between the first plate and the second plate, the movable plate is spaced apart from the secondary battery.

8. The experimental jig of claim 7, wherein the fixed plate is in close contact with the secondary battery.

9. The experimental jig of claim 6, wherein, as the movable plate is inserted between the first plate and the second plate, a distance between the movable plate and the fixed plate increases.

10. The experimental jig of claim 2, wherein one surface of the fixed plate that is in contact with the secondary battery comprises an arch structure.

11. The experimental jig of claim 10, wherein a length of the movable plate is greater than a length of the fixed plate.

12. The experimental jig of claim 1, wherein the side plate is provided in pair to be disposed on both sides of the secondary battery, respectively,
wherein one of the pair of side plates surrounds one surface of the secondary battery, and the other of the pair of side plates is spaced a constant distance from the other surface of the secondary battery.
